# EUROPEAN PATENT APPLICATION

(11) **EP 4 782 898 A1**
(43) Date of publication of application: **29.07.2026**
(21) Application number: 26154349.0
(22) Date of filing: 27.01.2026
(51) Int. Cl.: G02B 6/42, G02B 6/43, H10W 90/00

(54) **INTERFACE BETWEEN ELECTRONIC INTEGRATED CIRCUIT AND PHOTONIC INTEGRATED CIRCUIT**

(30) Priority: 28.01.2025 US 202519039535
(71) Applicant: Avago Technologies International Sales Pte. Limited, Singapore 768923 (SG)
(72) Inventor: Margalit, Near, Westlake Village, 91361 (US); Ramaswamy, Anand, Pasadena, 91107 (US)
(74) Representative: Dilg, Haeusler, Schindelmann Patentanwaltsgesellschaft mbH

(57) **Abstract**

An example integrated circuit (IC) assembly can include a first electrical integrated circuit (EIC) electrically and mechanically coupled to a substrate and including a first and a second die-to-die interface circuit. The IC assembly can include a first optical transceiver engine electrically and mechanically coupled to the substrate and including a third and a fourth die-to-die interface circuit. The IC assembly can include a second optical transceiver engine electrically and mechanically coupled to the substrate and including a fifth and a sixth die-to-die interface circuit. The third die-to-die interface circuit can be electrically coupled to the first die-to-die interface circuit by first conductors of the substrate. The fifth die-to-die interface circuit can be electrically coupled to the second die-to-die interface circuit by second conductors of the substrate. The fourth and the sixth die-to-die interface circuits can be configured as disconnected from power supplies of the first and second optical transceiver engines, respectively.

## Description

### BACKGROUND

A substrate may be a component that supports and couples devices, such as integrated circuits (ICs). A substrate disposed between devices and another substrate may be referred to as an interposer. A substrate can be formed from organic material. Some substrates, such as interposers, can be a combination of organic material and semiconductor material (e.g., silicon). Such an interposer can include a higher density bump pitch than a general purpose substrate. The devices attached to a substrate can be electrical, optical, or a combination thereof. Electrical devices may be devices that operate using electrical signals. Optical devices (also referred to as photonic devices) may be devices that operate using a combination of light and electrical signals. An electronic IC (EIC) may be an IC that includes electronic devices, such as transistors, capacitors, resistors, and the like. A photonic IC (PIC) may be an IC that includes optical devices, such as waveguides, light modulators, lasers, and the like. An IC assembly may be a plurality of ICs that are communicatively coupled (e.g., by a substrate). Within an IC assembly, constituent ICs may be referred to as chiplets.

A substrate can include conductive contacts for electrically and mechanically interfacing with another substrate. These conductive contacts can be balls of solder, sometimes referred to as solder balls, solder bumps, or bumps. Likewise, an IC can include bumps for interfacing with a substrate. A substrate can include conductive contacts for interfacing with the bumps of an IC. During fabrication, heat can be applied to temporarily melt bumps to form mechanical and electrical bonds (e.g., IC-to-substrate bonds, substrate-to-substrate bonds, etc.). In some cases, substrates can support fine bump pitches, such as less than 60 micrometers. Such substrates can be used to connect components (e.g., ICs) near each other in an IC assembly.

ICs can include die-to-die interfaces for connecting to other ICs through a substrate. A die may be a substrate of an IC (e.g., a semiconductor substrate, organic substrate, etc.). A die-to-die interface may be one or more electronic transceivers. An electronic transceiver may be an electronic circuit that can transmit and receive a plurality of electrical signals. It is desirable to design die-to-die interfaces for maximizing bandwidth while minimizing power consumption for input/output (IO) communication between the ICs. However, the bandwidth and power efficiency of these interfaces can come at the expense of reach and speed. For example, the reach of such interfaces can be limited to a few millimeters and the speed can be limited to less than 50 gigabits per second for a nonreturn-to-zero (NRZ) signal. The implications of these constraints can be that: (1) the chiplets need to be near each other and (2) the signals cannot be fanned out on the substrate as is done on conventional IC assemblies.

Moreover, there is an emerging trend to place optical transceivers on an interposer. An optical transceiver engine may be a photonic device paired with an electronic device that can transmit and receive optical signals. The optical transceiver engine can be disposed in an IC assembly with an EIC, such as an application specific integrated circuit (ASIC). The PIC and ASIC may be near each other on a substrate. Conventionally, PICs have not been placed very near EICs, such as compute application specific integrated circuits (ASICs) (e.g., graphics processing units (GPUs), Ethernet dies, etc.). The size of PICs can be significantly larger than the size of EICs, e.g., including bump and fiber pitch. This can create a bump pitch mismatch, requiring conductors on a substrate to be fanned out from the EICs to the PICs. However, the fan out can violate the constraints described above for chiplets in close proximity.

### SUMMARY

In some embodiments, an integrated circuit (IC) assembly can include_a first electrical integrated circuit (EIC) electrically and mechanically coupled to a substrate, the first EIC including a first and a second die-to-die interface circuit. The IC assembly can include a first optical transceiver engine electrically and mechanically coupled to the substrate, the first optical transceiver engine including a third and a fourth die-to-die interface circuit. The IC assembly can include a second optical transceiver engine electrically and mechanically coupled to the substrate, the second optical transceiver engine including a fifth and a sixth die-to-die interface circuit. The third die-to-die interface circuit can be electrically coupled to the first die-to-die interface circuit by first conductors of the substrate. The fifth die-to-die interface circuit can be electrically coupled to the second die-to-die interface circuit by second conductors of the substrate. The fourth and the sixth die-to-die interface circuits can be configured as disconnected from power supplies of the first and second optical transceiver engines, respectively.

In some embodiments, a method of fabricating an integrated circuit (IC) assembly can include_coupling a first electrical integrated circuit (EIC) electrically and mechanically to a substrate, the first EIC including a first and a second die-to-die interface circuit. The method can include coupling a first optical transceiver engine electrically and mechanically to the substrate, the first optical transceiver engine including a third and a fourth die-to-die interface circuit. The method can include coupling a second optical transceiver engine electrically and mechanically to the substrate, the second optical transceiver engine including a fifth and a sixth die-to-die interface circuit. The method can include coupling the third die-to-die interface circuit electrically to the first die-to-die interface circuit by first conductors of the substrate. The method can include coupling the fifth die-to-die interface circuit electrically to the second die-to-die interface circuit by second conductors of the substrate. The method can include configuring the fourth and the sixth die-to-die interface circuits as disconnected from power supplies of the first and second optical transceiver engines, respectively.

In some embodiments, an apparatus can include first and second optical connectors and_an integrated circuit (IC) assembly. The IC assembly can include a first electrical integrated circuit (EIC) electrically and mechanically coupled to a substrate, the first EIC including a first and a second die-to-die interface circuit. The IC assembly can include a first optical transceiver engine electrically and mechanically coupled to the substrate, the first optical transceiver engine including a third and a fourth die-to-die interface circuit, the first optical transceiver engine coupled to the first optical connector. The IC assembly can include a second optical transceiver engine electrically and mechanically coupled to the substrate, the second optical transceiver engine including a fifth and a sixth die-to-die interface circuit, the second optical transceiver engine coupled to the second optical connector. The third die-to-die interface circuit can be electrically coupled to the first die-to-die interface circuit by first conductors of the substrate. The fifth die-to-die interface circuit electrically can be coupled to the second die-to-die interface circuit by second conductors of the substrate. The fourth and the sixth die-to-die interface circuits can be configured as disconnected from power supplies of the first and second optical transceiver engines, respectively.

### BRIEF DESCRIPTION OF THE DRAWINGS

Fig. 1A is a plan view of an IC assembly.
Fig. 1B is a side view of a substrate and an ASIC.
Fig. 1C is a side view of an optical transceiver engine.
Fig. 1D is a plan view showing a substrate in relation to an optical transceiver engine on substrate 108.
Fig. 2A is a plan view of an IC assembly according to some embodiments.
Fig. 2B shows a side view of an ASIC according to some embodiments.
Fig. 2C shows a side view of an optical transceiver engine according to some embodiments.
Fig. 2D is a plan view showing a portion of an IC assembly according to some embodiments.
Fig. 3 is a flow diagram depicting a method of fabricating an IC assembly according to some embodiments.
Fig. 4 is a block diagram depicting a device according to some embodiments.

### DETAILED DESCRIPTION

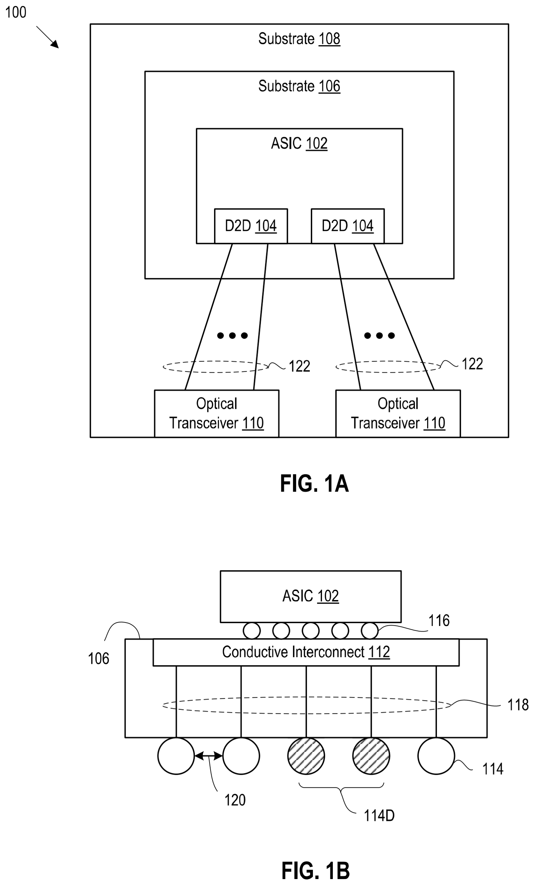

Fig. 1A is a plan view of an IC assembly 100. IC assembly 100 can include an application specific integrated circuit (ASIC) 102 and a plurality of optical transceiver engines 110 (e.g., two are shown by way of example) on a substrate 108. An ASIC may be an EIC customized for a particular use. An optical transceiver engine may be a device implementing an optical transceiver. An optical transceiver may be a device that can transmit and receive optical signals. For example, ASIC 102 may be customized for processing network packets, such as Ethernet frames (e.g., an ASIC used in a network switch). ASICs, however, can have a myriad of customized uses as is known in the art. While ASIC 102 is shown in the example, it is to be understood that other types of EICs can be used, such as a general-purpose processor (e.g., a central processing unit (CPU), a graphics processing unit (GPU), etc.). ASIC 102 can be electrically coupled and mechanically attached to a substrate 106. Substrate 106 can support other devices (not shown) that can be coupled to ASIC 102. In some embodiments, substrate 106 can be omitted and ASIC 102 can be mechanically attached and electrically coupled to substrate 108. In the embodiment shown, substrate 106 can be referred to as an interposer, which may be a substrate interposed between device(s) and another substrate. ASIC 102 can include a plurality of die-to-die (D2D) interfaces 104. A D2D interface may be a circuit that can transmit and receive signals, e.g., between dies. A die a semiconductor portion of an IC.

Fig. 1B is a side view of substrate 106 and ASIC 102. Substrate 106 can include conductive interconnect 112. Conductive interconnect may be layers of patterned conductors separated by layers of dielectric. ASIC 102 can be electrically coupled and mechanically attached to substrate 106 through bumps 116. Bumps 116 can be mechanically attached and electrically coupled to conductive interconnect 112. Substrate 106 can include bumps 114. Conductive interconnect 112 can be electrically coupled to bumps 114 using vias 118. A via may be a hole that can be filled with a conductor for making electrical connections. Bumps 114 can have a pitch 120. A pitch of bumps ("bump pitch") may be a measure of spacing between bumps. Some bumps 114, e.g., bumps 114D, can be electrically coupled to D2D interfaces 104.

Returning to Fig. 1A, substrate 106 can be electrically coupled and mechanically attached to substrate 108 (e.g., via bumps 114). Substrate 108 can include conductors that electrically couple ASIC 102 and optical transceiver engines 110. Each D2D 104 can be electrically coupled to a corresponding optical transceiver engine 110 through conductors 122 on substrate 108. Conductors 122 can be electrically coupled to bumps 114D of substrate 106.

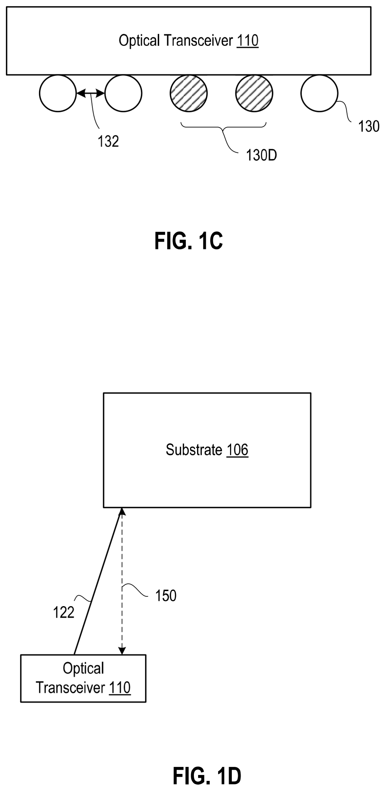

Fig. 1C is a side view of an optical transceiver engine 110. Optical transceiver engine 110 can include bumps 130. Bumps 130 can include a pitch 132. Some bumps 130, e.g., bumps 130D, can be electrically coupled to bumps 114D of substrate 106 via conductors 122. Pitch 132 can be different than pitch 120, e.g., pitch 132 can be larger than pitch 120. This can result in fan-out of conductors 122 between substrate 106 and each optical transceiver engine 110. Fan-out of conductors in IC assembly may be the characteristic of the conductors being longer than the distance between the devices they are coupling. For example, at least a portion of conductors 122 can be longer than the distance between substrate 106 and each optical transceiver engine 110. Other factors affecting the fan-out of conductors 122 include the size and positioning of optical transceiver engines 110 relative to the size and positioning of substrate 106 on substrate 108.

Fig. 1D is a plan view showing substrate 106 in relation to an optical transceiver engine 110 on substrate 108. Substrate 106 can be disposed on substrate 108 at a distance 150 from optical transceiver engine 110. Substrate 106 can be electrically coupled to optical transceiver engine 110 by conductors 122 as discussed above (e.g., one conductor 122 is shown in Fig. 1D). The length of conductor 122 can be longer than distance 150 due to fan-out as discussed above.

As discussed above, the bandwidth and power efficiency of electrical interfaces (e.g., D2Ds 104) can be affected by fan-out of conductors coupling the electrical interfaces. For example, fan-out of conductors 122 can reduce the bandwidth, power efficiency, or both of D2Ds 104 in ASIC 102. This can deleteriously affect communication between ASIC 102 and optical transceiver engines 110 (e.g., reduce the bandwidth of the communication, reduce the power efficiency of the communication, or both). Bandwidth may be a set of frequencies used by signals between components (e.g., the amount of information that can be transmitted per unit of time). Power efficiency may be a measure of the ability to convert electrical power into useful work.

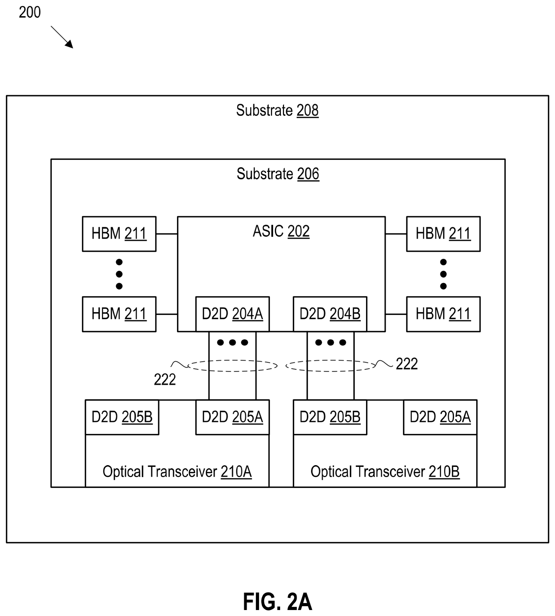

Fig. 2A is a plan view of an IC assembly 200 according to some embodiments. IC assembly 200 includes a substrate 206 that is electrically coupled and mechanically attached to a substrate 208. Substrate 208 can include other devices (not shown). An ASIC 202 and optical transceiver engines 210 (e.g., two are shown) are electrically coupled and mechanically attached to substrate 206. In some embodiments, additional components can be mounted on substrate 206, such as high-bandwidth memories (HBMs) and the like. An HBM may be a memory that exhibits a bandwidth considered to be high with respect to conventional memories. In the example, HBMs 211 can be mounted on substrate 206 (e.g., electrically coupled and mechanically attached to substrate 206) adjacent to ASIC 202, such as on the left and right of ASIC 202 with respect to the plan view. Optical transceiver engines 210 can be disposed adjacent to ASIC 202, such as in front or back of ASIC 202 with respect to the plan view (e.g., the front and back being orthogonal to the left and right of ASIC 202). In the example shown, two optical transceiver engines 210A and 210B are disposed adjacent to the front of ASIC 202.

Each optical transceiver engine 210 can include a plurality of D2Ds 205, e.g., two D2Ds 205A and 205B are shown. Each D2D 205 can be in one of a plurality of locations of optical transceiver engine 210. Assume in the example that D2D 205A can be in a location A and D2D 205B can be in a location B. In the example, ASIC 202 can include two D2Ds 204A and 204B. D2D 204A of ASIC 202 can be electrically coupled to D2D 205A of an optical transceiver engine 210A by conductors 222 of substrate 206. D2D 204B of ASIC 202 can be electrically coupled to D2D 205B of optical transceiver engine 210B.

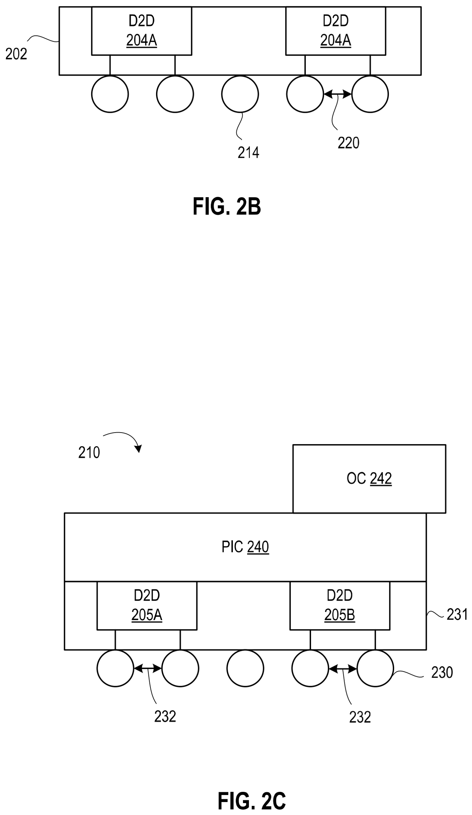

Fig. 2B shows a side view of ASIC 202 according to some embodiments. ASIC 202 can include bumps 214 having a pitch 220. D2D 204A of ASIC 202 can be electrically coupled to some of bumps 214 (e.g., two bumps shown). D2D 204B of ASIC 202 can be electrically coupled to some of bumps 214 (e.g., two bumps shown).

Fig. 2C shows a side view of an optical transceiver engine 210 according to some embodiments. Optical transceiver engine 210 can include an EIC 231 and a PIC 240 integrated with one another. An optical connector (OC) 242 can be coupled to PIC 240 for sending and receiving optical signals. EIC 231 can include bumps 230 for sending and receiving electrical signals. Bumps 230 can have a pitch 232. Bumps 230 can be electrically coupled and mechanically attached to interposer 206. Likewise, bumps 214 of ASIC 202 can be electrically coupled and mechanically attached to substrate 206. In some embodiments, pitch 232 and pitch 220 can be the same or substantially similar. D2D 205A can be formed in EIC 231. D2D 205A can be electrically coupled to some of bumps 230 (e.g., two bumps shown). D2D 205B can be formed in EIC 231. D2D 205B can be electrically coupled to some of bumps 230 (e.g., two bumps shown). The structure of optical transceiver engine 210 in Fig. 2C is one example structure. In another embodiment, the PIC 240 and EIC 231 can be swapped such that bumps 230 are on PIC 240. In yet another embodiment, PIC 240 and EIC 231 can be mounted to a substrate (e.g., interposer) adjacent to each other.

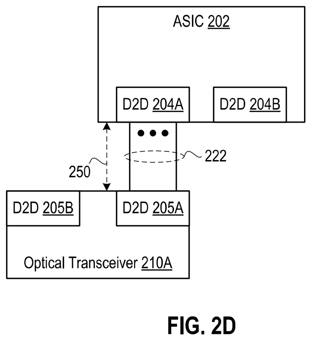

Fig. 2D is a plan view showing a portion of IC assembly 200 according to some embodiments. Optical transceiver engine 210A can be disposed on substrate 206 a distance 250 from ASIC 202. Since pitch 232 and pitch 220 can be the same or substantially the same, bumps 230 coupled to D2D 205A can be aligned with bumps 214 coupled to D2D 204A. Such an alignment eliminates or minimizes fan-out of conductors 222. Thus, the lengths of conductors 222 between ASIC 202 and optical transceiver engine 210A can be minimized (e.g., the same as or substantially the same as distance 250 between ASIC 202 and optical transceiver engine 210A). Optical transceiver engine 210B can be configured similarly.

In the example, D2D 205A can be configured to be inactive in optical transceiver engine 210B. Likewise, D2D 205B can be configured to be inactive in optical transceiver engine 210A. By inactive, it is meant that the D2D may be configured to be disconnected from a power supply of the optical transceiver engine. D2D 205A can be electrically coupled to some of bumps 230 (e.g., two bumps shown). The bumps 230 coupled to D2D 205A can be mechanically attached to substrate 206. The bumps 230 coupled to D2D 205A are not electrically coupled to ASIC 202. In some embodiments, the bumps 230 coupled to D2D 205A can be electrically isolated from any other component on substrate 206. In other embodiments, bumps 230 coupled to D2D 205A can be electrically coupled to electrical ground or other reference potential.

Eliminating or minimizing fan-out of conductors 222 between ASIC 202 and optical transceiver engines 210A and 210B can increase bandwidth and/or power efficiency of the communication therebetween. Moreover, optical transceiver engines 210 can be fabricated using the same design. Some optical transceiver engines 210 can be mounted on the substrate in a position the same or similar to that of optical transceiver engine 210A. Other optical transceiver engines 210 can be mounted on the substrate in a position the same or similar to that of optical transceiver engine 210B. It is not required to fabricate two different optical transceiver engines with two different layouts. While the example shows two D2D locations A and B, in other embodiments there can be more than two locations.

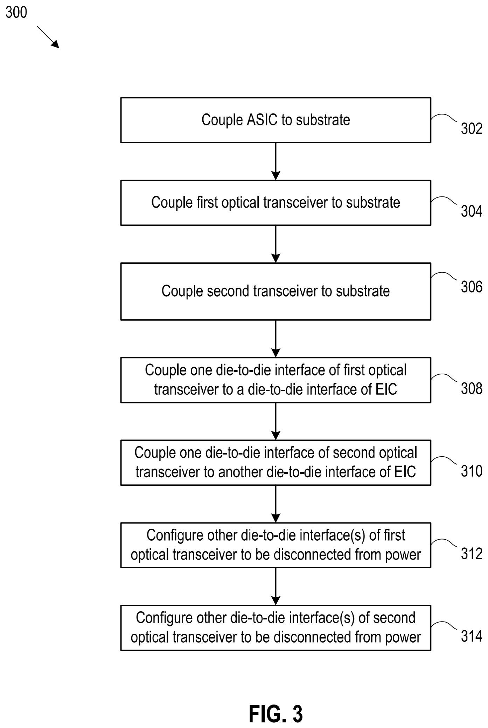

Fig. 3 is a flow diagram depicting a method 300 of fabricating an IC assembly according to some embodiments. Method 300 begins at step 302, where ASIC 202 can be mounted to substrate 206 (e.g., electrically coupled and mechanically attached to substrate 206). At step 304, optical transceiver engine 210A can be mounted to substrate 206 (e.g., electrically coupled and mechanically attached to substrate 206). At step 306, optical transceiver engine 210B engine can be mounted to substrate 206 similar to optical transceiver engine 210A. At step 308, D2D 205A can be coupled to D2D 204A. At step 310, D2D 205B can be coupled to D2D 204B. At step 312, D2D 205B (and any other D2D) can be disconnected from power in optical transceiver engine 210A. At step 314, D2D 205A (and any other D2D can be disconnected from power in optical transceiver 210B. In some embodiments, D2Ds that are inactive can be disconnected from power by a switch controlled by a programmable memory (e.g., a one-time programmable memory). Data can be written to the memory to control the switch to be open, which will cause the respective D2D to be inactive. For D2Ds that are active, data can be written to the memory to control the switch to be close, connecting the D2Ds to power.

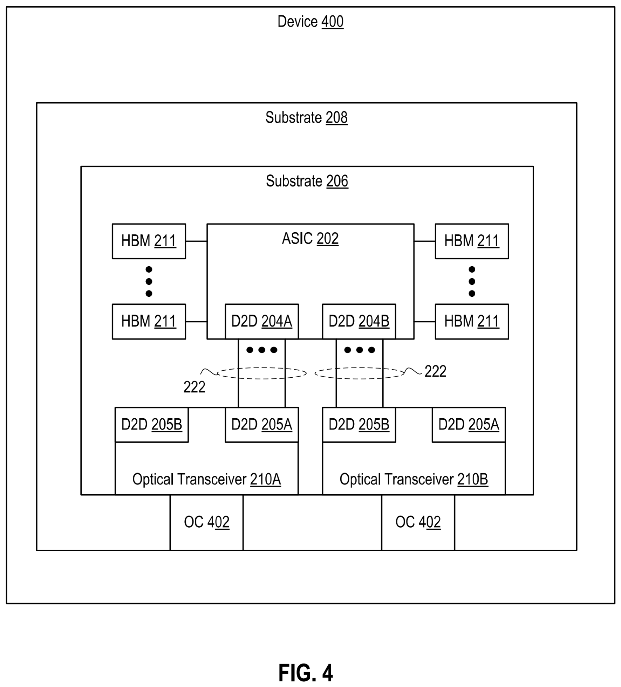

Fig. 4 is a block diagram depicting a device 400 according to some embodiments. For example, device 400 can be a network device, such as a network switch. Device 400 can include an IC assembly 200. Device 400 can include OCs 402 mounted on substrate 208. OCs 402 can be coupled to optical transceiver engines 210A and 210B.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. An integrated circuit, IC, assembly, comprising:
a first electrical integrated circuit, EIC, electrically and mechanically coupled to a substrate, the first EIC including a first and a second die-to-die interface circuit;
a first optical transceiver engine electrically and mechanically coupled to the substrate, the first optical transceiver engine including a third and a fourth die-to-die interface circuit;
a second optical transceiver engine electrically and mechanically coupled to the substrate, the second optical transceiver engine including a fifth and a sixth die-to-die interface circuit;
the third die-to-die interface circuit electrically coupled to the first die-to-die interface circuit by first conductors of the substrate;
the fifth die-to-die interface circuit electrically coupled to the second die-to-die interface circuit by second conductors of the substrate;
the fourth and the sixth die-to-die interface circuits being configured as disconnected from power supplies of the first and second optical transceiver engines, respectively.

2. The IC assembly of claim 1, wherein
the first EIC is disposed on the substrate at a first distance from each of the first and the second optical transceiver engines, and wherein lengths of the first and the second conductors are approximately equal to the first distance.

3. The IC assembly of claim 1 or 2, wherein
the first optical transceiver engine includes a first photonic IC, PIC, and a second EIC, wherein
the second optical transceiver engine includes a second PIC and a third EIC, wherein the second EIC includes the third and the fourth die-to-die interface circuits, and wherein the third EIC includes the fifth and the sixth die-to-die interface circuits.

4. The IC assembly of claim 3, wherein
the second EIC and the third EIC have the same layout.

5. The IC assembly of any one of the claims 1 to 4, further comprising:
additional ICs electrically and mechanically coupled to the substrate adjacent to first and second sides of the first EIC, the first and second sides being parallel to each other;
wherein the first and the second optical transceiver engines are adjacent to a third side of the first EIC that is orthogonal to the first and the second sides.

6. The IC assembly of any one of the claims 1 to 5, wherein
the first EIC includes a first set of bumps bonded to the substrate and the first optical transceiver engine includes a second set of bumps bonded to the substrate, wherein the first die-to-die interface circuit is electrically coupled to the first set of bumps, wherein the third die-to-die interface circuit is electrically coupled to the second set of bumps, and wherein the first set of bumps and the second set of bumps have approximately the same pitch.

7. The IC assembly of claim 6, wherein
the first and the second optical transceiver engines are adjacent to a first side of the first EIC, and
wherein the first set of bumps are approximately aligned with the second set of bumps along an axis orthogonal to the first side of the EIC.

8. A method of fabricating an integrated circuit, IC, assembly, comprising:
coupling a first electrical integrated circuit, EIC, electrically and mechanically to a substrate, the first EIC including a first and a second die-to-die interface circuit;
coupling a first optical transceiver engine electrically and mechanically to the substrate, the first optical transceiver engine including a third and a fourth die-to-die interface circuit;
coupling a second optical transceiver engine electrically and mechanically to the substrate, the second optical transceiver engine including a fifth and a sixth die-to-die interface circuit;
coupling the third die-to-die interface circuit electrically to the first die-to-die interface circuit by first conductors of the substrate;
coupling the fifth die-to-die interface circuit electrically to the second die-to-die interface circuit by second conductors of the substrate;
configuring the fourth and the sixth die-to-die interface circuits as disconnected from power supplies of the first and second optical transceiver engines, respectively.

9. The method of claim 8, wherein
the first EIC is disposed on the substrate at a first distance from each of the first and the second optical transceiver engines, and wherein lengths of the first and the second conductors are approximately equal to the first distance.

10. The method of claim 8 or 9, wherein
the first optical transceiver engine includes a first photonic IC, PIC, and a second EIC, wherein
the second optical transceiver engine includes a second PIC and a third EIC, wherein the second EIC includes the third and the fourth die-to-die interface circuits, and wherein the third EIC includes the fifth and the sixth die-to-die interface circuits.

11. The method of claim 10, wherein
the second EIC and the third EIC have the same layout.

12. The method of any one of the claims 8 to 11, further comprising:
coupling additional ICs electrically and mechanically to the substrate adjacent to first and second sides of the first EIC, the first and second sides being parallel to each other;
the first and the second optical transceiver engines being adjacent to a third side of the first EIC that is orthogonal to the first and the second sides.

13. The method of any one of the claims 8 to 12, wherein
the first EIC includes a first set of bumps bonded to the substrate and the first optical transceiver engine includes a second set of bumps bonded to the substrate, wherein the first die-to-die interface circuit is electrically coupled to the first set of bumps, wherein the third die-to-die interface circuit is electrically coupled to the second set of bumps, and wherein the first set of bumps and the second set of bumps have approximately the same pitch.

14. The method of claim 13, wherein
the first and the second optical transceiver engines are adjacent to a first side of the first EIC, and wherein
the first set of bumps are approximately aligned with the second set of bumps along an axis orthogonal to the first side of the EIC.

15. An apparatus, comprising:
first and second optical connectors; and
an IC assembly as set forth in any one of the preceding claims 1 to 7,
wherein the first optical transceiver engine is coupled to the first optical connector and
wherein the second optical transceiver engine is coupled to the second optical connector.
